# EUROPEAN PATENT APPLICATION

(11) **EP 4 030 473 A1**
(43) Date of publication of application: **20.07.2022**
(21) Application number: 20862723.2
(22) Date of filing: 12.08.2020
(51) Int. Cl.: H01L 23/00, H05K 9/00, H05K 1/02, H05K 1/03, H05K 3/28

(54) **WIRING CIRCUIT BOARD**

(30) Priority: 13.09.2019 JP 2019166948
(71) Applicant: Nitto Denko Corporation, Ibaraki-shi Osaka 567-8680 (JP)
(72) Inventor: MATSUTOMI, Akihito, Ibaraki-shi, Osaka 567-8680 (JP); HODONO, Masayuki, Ibaraki-shi, Osaka 567-8680 (JP)
(74) Representative: Hoffmann Eitle
(86) International application number: PCT/JP2020/030723
(87) International publication number: WO 2021/049242

(57) **Abstract**

A wiring circuit board 1 includes an insulating base layer 2, a conductive layer 3 disposed on a one-side surface in a thickness direction of the insulating base layer 2, a cover insulating layer 4 disposed on the one-side surface in the thickness direction of the insulating base layer 2 to cover the conductive layer 3, and a shield layer 5 disposed on the other-side surface in the thickness direction of the insulating base layer 2 and both side surfaces in the width direction of the insulating base layer 2 and on a one-side surface in the thickness direction of the cover insulating layer 4 and both side surfaces in the width direction of the cover insulating layer 4. At least one of the insulating base layer 2 and the cover insulating layer 4 has a porous resin layer 10.

## Description

The present invention relates to a wiring circuit board.

### BACKGROUND ART

Coaxial cables have conventionally been used as power transmission channels.

For example, a coaxial cable for transmitting high frequency power, which includes a conductor and a jacket layer (insulating layer) disposed on the outer peripheral surface of the conductor, has been proposed (for example, see Patent document 1 below). The jacket layer of the coaxial cable for transmitting high frequency power described in Patent document 1 is made of a solid cross-linked polyethylene resin.

### Citation List

### Patent Document

Patent Document 1: Japanese Unexamined Patent Publication No. 2014-22146

### SUMMARY OF THE INVENTION

### PROBLEM TO BE SOLVED BY THE INVENTION

Coaxial cables for transmitting high frequency power have been required to have a greater efficiency in high-frequency signal transmission and be thinned in recent years.

The coaxial cable for transmitting high frequency power of Patent Document 1, however, includes a jacket layer made of a solid cross-linked polyethylene resin. This limits the improvement of the transmission efficiency.

There is a disadvantage that the coaxial cable structure of the coaxial cable for transmitting high frequency power of Patent Document 1 makes it difficult to thin the coaxial cable.

The present invention provides a wiring circuit board that can improve the high-frequency signal transmission efficiency and can be thinned.

### MEANS FOR SOLVING THE PROBLEM

The present invention [1] includes a wiring circuit board including: an insulating base layer; a conductive layer disposed on a one-side surface in a thickness direction of the insulating base layer; a cover insulating layer disposed on the one-side surface in the thickness direction of the insulating base layer so as to cover the conductive layer; and a shield layer disposed on the other-side surface in the thickness direction of the insulating base layer and both side surfaces in the width direction of the insulating base layer, and on a one-side surface in the thickness direction and both side surfaces in the width direction of the cover insulating layer, wherein at least one of the insulating base layer and the cover insulating layer has a porous resin layer.

The present invention [2] includes the wiring circuit board in [1], wherein a ratio (T2/T1) of a distance T2 between a one-side surface in the thickness direction of the conductive layer and the one-side surface in the thickness direction of the cover insulating layer to a distance T1 between the other-side surface in the thickness direction of the conductive layer and the other-side surface in the thickness direction of the insulating base layer is 0.9 or more and 1.1 or less.

The present invention [3] includes the wiring circuit board described in [1] or [2] above, wherein the porous resin layer has a closed cell structure.

The present invention [4] includes the wiring circuit board described in described in any one of the above-described [1] to [3], wherein the porous resin layer has a porosity of 50% or more.

The present invention [5] includes the wiring circuit board described in described in any one of the above-described [1] to [4], wherein a material of the porous resin layer is a polyimide resin.

The present invention [6] includes the wiring circuit board described in described in any one of the above-described [1] to [5], wherein the insulating base layer and the cover insulating layer is made of a porous resin layer.

The present invention [7] includes the wiring circuit board described in described in any one of the above-described [1] to [6], wherein the insulating base layer is made of the porous resin layer, the cover insulating layer includes an adhesive layer being in contact with a one-side surface in the thickness direction of the conductive layer and both side surfaces in the width direction of the conductive layer and with a part of the one-side surface in the thickness direction of the insulating base layer that does not overlap the conductive layer when being projected in the thickness direction, and the porous resin layer being in contact with a one-side surface in the thickness direction of the adhesive layer.

### EFFECTS OF THE INVENTION

In the wiring circuit board of the present invention, at least one of the insulating base layer and the cover insulating layer has the porous resin layer. Thus, the high-frequency signal transmission efficiency can be improved.

The wiring circuit board includes the insulating base layer and cover insulating layer having a layered shape, and thus can be thinned.

### BRIEF DESCRIPTION OF THE DRAWINGS

[FIG. 1] FIG. 1 is a cross-sectional view of the first embodiment of the wiring circuit board of the present invention.
[FIG. 2] FIG. 2A to FIG. 2F illustrate a process of producing the wiring circuit board of FIG. 1. FIG. 2A illustrates a step for preparing the other-side shield layer and an insulating base layer. FIG. 2B illustrates a step for disposing a conductive layer. FIG. 2C illustrates a step for disposing a cover insulating layer. FIG. 2D illustrates a step for disposing a one-side shield layer. FIG. 2E illustrates a step for forming an opening portion. FIG. 2F illustrates a step for disposing a side shield layer.
[FIG. 3] FIG. 3 is a cross-sectional view of a variation of the wiring circuit board of FIG. 1 (a mode in which the conductive layer includes a plurality of wires).
[FIG. 4] FIG. 4 is a cross-sectional view of the second embodiment of the wiring circuit board of the present invention (a mode in which the cover insulating layer includes a porous resin layer and an adhesive layer).
[FIG. 5] FIG. 5A to FIG. 5D illustrate a process of producing the wiring circuit board of FIG. 4. FIG. 5A illustrates a step for disposing an adhesive layer. FIG. 5B illustrates a step for bringing a cover insulating layer into contact with the adhesive layer. FIG. 5C illustrates a step for forming an opening portion. FIG. 5D illustrates a step for disposing a side shield layer.
[FIG. 6] FIG. 6 is a cross-sectional view of a variation of the wiring circuit board of FIG. 4 (a mode in which the conductive layer includes a plurality of wires).

### DESCRIPTION OF THE EMBODIMENTS

### <First Embodiment>

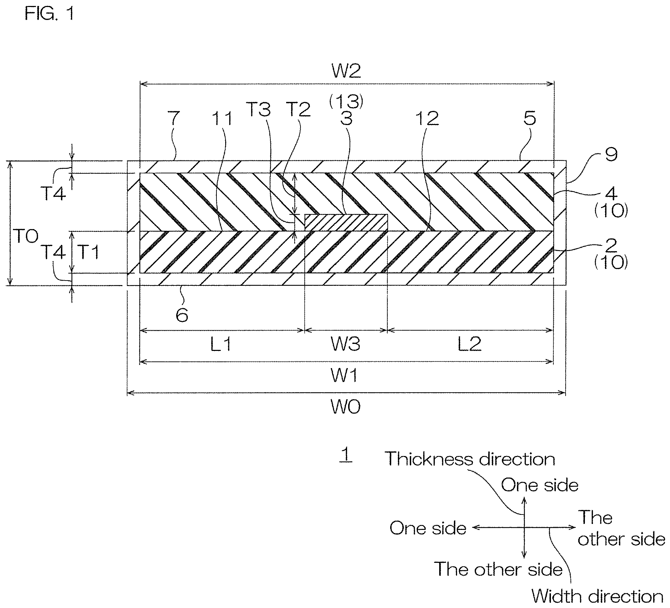

The first embodiment of the wiring circuit board of the present invention is described with reference to FIG. 1.

As illustrated in FIG. 1, a wiring circuit board 1 is, for example, a transmission channel that transmits signals (electric signals), preferably, a high-frequency transmission channel that transmits high-frequency signals (specifically, signals at a frequency of 1 GHz or more, further, at a frequency of 2 GHz or more and 100 GHz or less) (a cable for transmitting high-frequency signals). The wiring circuit board 1 has a flat belt shape extending along a transmission direction. The wiring circuit board 1 has a predetermined thickness in a cross-sectional view orthogonal to the transmission direction, and has an approximately rectangular shape extending in a width direction (orthogonal to the transmission direction and a thickness direction). The wiring circuit board 1 includes an insulating base layer 2, a conductive layer 3, a cover insulating layer 4, and a shield layer 5.

The insulating base layer 2 has an approximately rectangular shape with the longest side in the width direction in the cross-sectional view.

The insulating base layer 2 has a thickness T1 that is a distance T1 between the other-side surface in the thickness direction of the conductive layer 3 and the other-side surface in the thickness direction of the insulating base layer 2. Specifically, the thickness T1 of the insulating base layer 2 is, for example, 10 µm or more, preferably 30 µm or more, and, for example, 200 µm or less, preferably 75 µm or less. A ratio (T1/T0) of the thickness T1 of the insulating base layer 2 to a thickness T0 of the wiring circuit board 1 is, for example, 0.15 or more, preferably 0.3 or more, and, for example, 0.6 or less, preferably 0.45 or less.

The insulating base layer 2 has a width W1 that is a distance W1 between both side surfaces in the width direction of the insulating base layer 2. Specifically, the width W1 of the insulating base layer 2 is, for example, 100 µm or more, preferably 250 µm or more, and, for example, 500 µm or less, preferably 350 µm or less. A ratio (W1/W0) of the width W1 of the insulating base layer 2 to the width W0 of the wiring circuit board 1 is, for example, 0.8 or more, preferably 0.9 or more, and, for example, 1 or less, preferably 0.99 or less.

A ratio (T1/W1) of the thickness T1 to the width W1 of the insulating base layer 2 is, for example, 2.0 or less, preferably 1.5 or less, more preferably 1.0 or less, and, for example, 0.1 or more.

When the dimensions of the insulating base layer 2 is within the above-described range, the wiring circuit board 1 can be thinned while the high-frequency signal transmission efficiency can be improved.

The insulating base layer 2 is a porous resin layer 10 (see the number in parentheses of FIG. 1). The porous resin layer 10 has a lot of fine pores (air holes). Preferably, the porous resin layer 10 has a closed cell structure. When the porous resin layer 10 has a closed cell structure, the high-frequency signal transmission efficiency of the wiring circuit board 1 can be improved.

The porous resin layer 10 of the insulating base layer 2 has a porosity of, for example, 50% or more, preferably 60% or more, more preferably 70% or more, even more preferably 80% or more, and, for example, less than 100%. The porosity of the porous resin layer 10 is measured according to the description of International Patent Publication No. WO2018/186486. When the porosity of the porous resin layer 10 is the above-described lower limit or more, the high-frequency signal transmission efficiency of the wiring circuit board 1 can be improved.

The average pore diameter in the porous resin layer 10 of the insulating base layer 2 is, for example, 10 µm or less, preferably 5 µm or less, and, for example, 0.1 µm or more, preferably 1 µm or more. The average pore diameter in the porous resin layer 10 is measured according to the description of International Patent Publication No. WO2018/186486.

Examples of the material of the porous resin layer 10 of the insulating base layer 2 include resins such as thermosetting resin and thermoplastic resin. Preferably, thermosetting resin is used.

Examples of the thermosetting resin include polycarbonate resin, polyimide resin (thermosetting polyimide resin), thermosetting polyimide fluoride resin, epoxy resin, phenol resin, urea resin, melamine resin, diallyl phthalate resin, silicone resin, thermosetting urethane resin, fluorine resin (a polymer of fluorine-containing olefin (specifically, for example, polytetrafluoroethylene (PTFE)), and a liquid crystal polymer (LCP). These can be used singly or in combination of two or more. Preferably, polyimide resin is used. When the material of the porous resin layer 10 is polyimide resin, low cost and low permittivity are secured and the high-frequency signal transmission properties of the wiring circuit board 1 can be improved.

The insulating base layer 2 has a permittivity of, for example, 3.0 or less, preferably 2.5 or less, more preferably 2.0 or less at a frequency of 10 GHz.

The conductive layer 3 is disposed on a one-side surface in the thickness direction of the insulating base layer 2. Specifically, the conductive layer 3 is in contact with a central portion of the one-side surface in the thickness direction of the insulating base layer 2. The conductive layer 3 is, for example, a wire 13.

In the cross-sectional view, a one side part 11 is located at one side in the width direction with respect to the central portion of the one-side surface in the thickness direction of the insulating base layer 2 (a part with which the conductive layer 3 is in contact) is. The other side part 12 is located at the other side in the width direction with respect to the central portion of the one-side surface in the thickness direction of the insulating base layer 2 (the part with which the conductive layer 3 is in contact) is. A ratio (L2/L1) of a length L2 of the other side part 12 to a length L1 of the one side part 11 is, for example, 0.9 or more, preferably 0.95 or more, and, for example, 1.1 or less, preferably 1.05 or less. It is preferred that the length L1 of the one side part 11 and the length L2 of the other side part 12 are approximately the same in the insulating base layer 2. When the dimensions of the one side part 11 and other side part 12 are within the above-described ranges, the wiring circuit board 1 can be thinned while the high-frequency signal transmission efficiency can be improved.

The wire 13 has an approximately rectangular shape with the longest side in the width direction in the cross-sectional view.

The material of the conductive layer 3 is not especially limited, and examples thereof include metals such as copper, iron, silver, gold, aluminum, nickel, and alloys thereof (stainless steels and bronze). To obtain a low electrical resistance, preferably, copper or gold is used.

The conductive layer 3 has a thickness T3 of, for example, 0.1 µm or more, preferably 1 µm or more, and, for example, 100 µm or less, preferably 50 µm or less. A ratio (T3/T0) of the thickness T3 of the conductive layer 3 to the thickness T0 of the wiring circuit board 1 is, for example, 0.5 or less, preferably 0.3 or less, more preferably 0.2 or less, and, for example, 0.01 or more, preferably 0.05 or more.

The conductive layer 3 (wire 13) has a width W3 smaller than the width W1 of the insulating base layer 2. The width W3 of the conductive layer 3 is, for example, 5 µm or more, preferably 10 µm or more, and, for example, 200 µm or less, preferably 100 µm or less. A ratio of (W3/W1) of the width W3 of the conductive layer 3 to the width W1 of the insulating base layer 2 is, for example, 0.75 or less, preferably 0.50 or less, more preferably 0.25 or less, and, for example, 0.01 or more, preferably 0.05 or more. A ratio (T4/W3) of a thickness T4 to the width W3 is, for example, 0.75 or less, preferably 0.5 or less, and, for example, 0.01 or more, preferably 0.01 or more in the conductive layer 3.

When the dimensions of the conductive layer 3 are within the above-described ranges, the wiring circuit board 1 can be thinned while the high-frequency signal transmission efficiency can be improved.

The conductive layer 3 is a solid densified layer. Thus, the conductive layer 3 has a porosity of substantially 0%.

The cover insulating layer 4 is disposed on the one-side surface in the thickness direction of the insulating base layer 2 so as to cover the conductive layer 3. Specifically, the cover insulating layer 4 is in contact with the one-side surface in the thickness direction of the insulating base layer 2 around the conductive layer 3, and with a one-side surface in the thickness direction of the conductive layer 3 and both side surfaces in the width direction of the conductive layer 3. The insulating base layer 2 around the conductive layer 3 is a part of the insulating base layer 2 that does not overlap the conductive layer 3 when being projected in the thickness direction. The cover insulating layer 4 has an approximately U shape opening toward the other side in the thickness direction in the cross-sectional view. A one-side surface in the thickness direction of the cover insulating layer 4 is flat. Each of both side surfaces in the width direction of the cover insulating layer 4 is flush with each of both side surfaces in the width direction of the insulating base layer 2.

The cover insulating layer 4 has a thickness T2 that is a distance T2 between the one-side surface in the thickness direction of the conductive layer 3 and the one-side surface in the thickness direction of the cover insulating layer 4. The thickness T2 of the cover insulating layer 4 is, for example, 10 µm or more, preferably 30 µm or more, and, for example, 200 µm or less, preferably 75 µm or less. A ratio (T1/T0) of the thickness T2 of the cover insulating layer 4 to the thickness T0 of the wiring circuit board 1 is, for example, 0.15 or more, preferably 0.3 or more, and, for example, 0.6 or less, preferably 0.45 or less. When the dimensions of the cover insulating layer 4 is within the above-described ranges, the wiring circuit board 1 can be thinned while the high-frequency signal transmission efficiency can be improved.

A ratio (T2/T1) of the thickness T2 of the cover insulating layer 4 to the thickness T1 of the insulating base layer 2 is, for example, 0.9 or more, preferably 0.95 or more, and, for example, 1.1 or less, preferably 1.05 or less. When the ratio (T2/T1) of the thickness T2 of the cover insulating layer 4 to the thickness T1 of the insulating base layer 2 is the above-described lower limit or more and the upper limit or less, great high-frequency signal transmission efficiency can be secured.

The thickness T1 of the insulating base layer 2 is a length from the shield layer 5 facing the insulating base layer 2 (the other-side shield layer 6 described below) to the conductive layer 3. The thickness T2 of the cover insulating layer 4 is a length from the shield layer 5 facing the cover insulating layer 4 (a one-side shield layer 7 described below) to the conductive layer 3. When the ratio thereof (T2/T1) is 0.9 or more and 1.1 or less, the above-described two lengths can substantially be identical. In other words, the thickness T2 of the cover insulating layer 4 can approximately be the same as the thickness T1 of the insulating base layer 2.

Thus, the effect of the magnetic field from the other side in the thickness direction on the conductive layer 3 and the effect of the magnetic field from the one side in the thickness direction on the conductive layer 3 can cancel each other. Accordingly, the effect of the outside magnetic field on the conductive layer 3 can be suppressed. As a result, the wiring circuit board 1 can further more improve its high-frequency signal transmission efficiency.

The cover insulating layer 4 has a width W2 identical to the width W1 of the insulating base layer 2. A ratio (W2/W0) of the width W2 of the cover insulating layer 4 to the width W0 of the wiring circuit board 1 is, for example, 0.8 or more, preferably 0.9 or more, and, for example, 1 or less, preferably 0.99 or less. A ratio (T2/W2) of the thickness T2 to the width W2 of the cover insulating layer 4 is, for example, 2.0 or less, preferably 1.5 or less, more preferably 1.0 or less, and, for example, 0.1 or more. The dimensions of the cover insulating layer 4 is within the above-described ranges, the wiring circuit board 1 can be thinned while the high-frequency signal transmission efficiency can be improved.

The cover insulating layer 4 is the porous resin layer 10. The porous resin layer 10 of the cover insulating layer 4 has the same structure (closed cell structure), properties (porosity, average pore diameter, and permittivity), and material (resin) (preferably a polyimide resin) as those of the porous resin layer 10 of the insulating base layer 2.

The shield layer 5 covers an outer peripheral surface of the insulating base layer 2 and an outer peripheral surface of the cover insulating layer 4 in the cross-sectional view. Specifically, the shield layer 5 is disposed on the other-side surface in the thickness direction of the insulating base layer 2 and both side surfaces in the width direction of the insulating base layer 2, and on the one-side surface in the thickness direction of the cover insulating layer 4 and both side surfaces in the width direction of the cover insulating layer 4. The shield layer 5 disposed on the one-side surface in the width direction of the insulating base layer 2 and the shield layer 5 disposed on the one-side surface in the width direction of the cover insulating layer 4 continue in the thickness direction. The shield layer 5 disposed on the other-side surface in the width direction of the insulating base layer 2 and the shield layer 5 disposed on the other-side surface in the width direction of the cover insulating layer 4 continue in the thickness direction. Thus, the shield layer 5 has an approximately rectangular shape in the cross-sectional view.

The shield layer 5 is a ground layer (earth ground layer), and grounded at one end not illustrated in the transmission direction (having a potential of 0).

The shield layer 5 has a thickness T4 of, for example, 0.01 µm or more, preferably 0.1 µm or more, and, for example, 18 µm or less, preferably 12 µm or less. The thickness T4 of the shield layer 5 remains approximately the same in a peripheral direction of the insulating base layer 2 and cover insulating layer 4. A ratio (T4/T0) of the thickness T4 of the shield layer 5 to the thickness T0 of the wiring circuit board 1 is, for example, 0.1 or less, preferably 0.01 or less, more preferably 0.001 or less, and, for example, 0.0001 or more. A ratio (T4/T3) of the thickness T4 of the shield layer 5 to the thickness T3 of the conductive layer 3 is, for example, 1 or less, preferably 0.1 or less, more preferably 0.01 or less, and, for example, 0.0001 or more.

The material of the shield layer 5 is the same as that of the conductive layer 3. The shield layer 5 is a solid densified layer. Thus, the shield layer 5 has a porosity of substantially 0%.

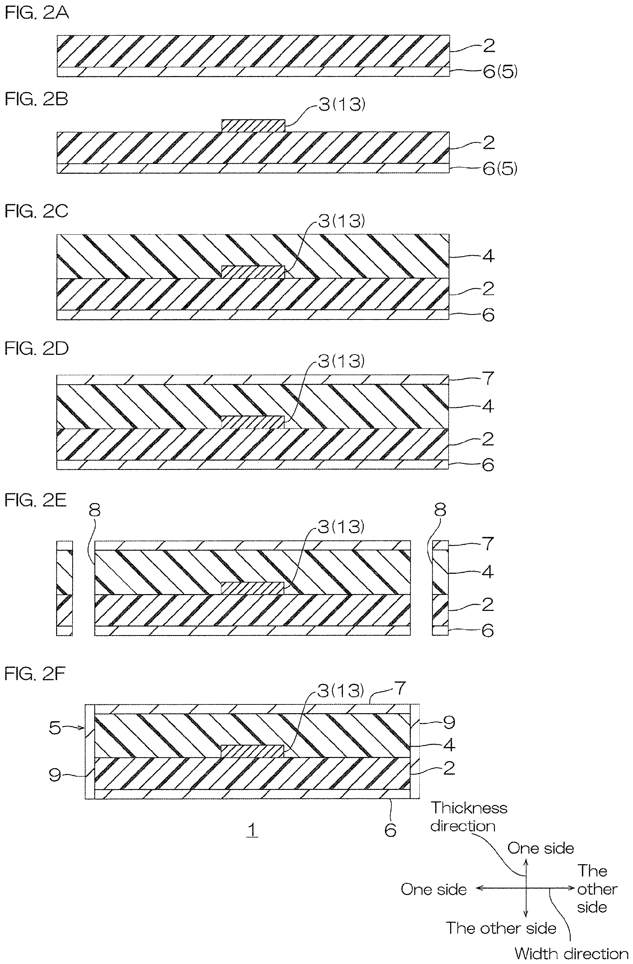

Next, an exemplary method of producing the wiring circuit board 1 is described with reference to FIG. 2A to FIG. 2F. Each step described below can be carried out, for example, according to the description in International Patent Publication No. WO2018/186486.

As illustrated in FIG. 2A, first in this method, the other-side shield layer 6, and the insulating base layer 2 disposed on a one-side surface in the thickness direction of the other-side shield layer 6 are prepared. The other-side shield layer 6 is a layer included in the shield layer 5, and is a part disposed on the other-side surface in the thickness direction of the insulating base layer 2. A laminate of the insulating base layer 2 laminated on the other-side shield layer 6 in advance can be prepared. Alternatively, the other-side shield layer 6 is prepared, and then the insulating base layer 2 can be disposed on the one-side surface in the thickness direction of the other-side shield layer 6.

As illustrated in FIG. 2B, next in this method, the conductive layer 3 is disposed on the one-side surface in the thickness direction of the insulating base layer 2. For example, by an additive manufacturing method or a subtractive manufacturing method, the conductive layer 3 having the wire 13 is formed on the one-side surface in the thickness direction of the insulating base layer 2.

As illustrated in FIG. 2C, next in this method, the cover insulating layer 4 is disposed on the one-side surface in the thickness direction of the insulating base layer 2 so as to cover the conductive layer 3.

As illustrated in FIG. 2D, next in this method, the one-side shield layer 7 is disposed on the one-side surface in the thickness direction of the cover insulating layer 4. For example, by plating or spattering, the one-side shield layer 7 is formed on the whole of the one-side surface in the thickness direction of the cover insulating layer 4. The one-side shield layer 7 is a layer included in the shield layer 5, and is a part disposed on the one-side surface in the thickness direction of the cover insulating layer 4.

As illustrated in FIG. 2E, next in this method, an opening portion 8 is formed on the other-side shield layer 6, the insulating base layer 2, the cover insulating layer 4, and the one-side shield layer 7. Specifically, the opening portion 8 is formed in a region through the other-side shield layer 6, insulating base layer 2, cover insulating layer 4, and one-side shield layer 7 that does not overlap the conductive layer 3 when being projected in the thickness direction. Two opening portions 8 are provided while holding the conductive layer 3 therebetween, when being projected in the thickness direction. The opening portion 8 is, for example, a slit penetrating the other-side shield layer 6, the insulating base layer 2, the cover insulating layer 4, and the one-side shield layer 7 in the thickness direction. The opening portions 8 extend in the transmission direction. In this manner, the wiring circuit board 1 (the wiring circuit board 1 without a shield layer 5 to be formed on its side surfaces) is defined between the opening portions 8. The wiring circuit board 1 is separated from an external part located outside relative to the opening portion 8.

To form the opening portion 8, for example, a laser, a dicing saw, or a drill is used.

As illustrated in FIG. 2F, next in this method, side shield layers 9 are formed on both side surfaces in the width direction of the insulating base layer 2 and on both side surfaces in the width direction of the cover insulating layer 4. The side shield layer 9 is a layer included in the shield layer 5. The method for forming the side shield layer 9 is the same as the method for forming the one-side shield layer 7. The other ends in the thickness direction of the side shield layers 9 continue to both ends in the width direction of the other-side shield layer 6, respectively. One ends in the thickness direction of the side shield layers 9 continue to both ends in the width direction of the one-side shield layer 7, respectively. In this manner, the shield layer 5 made of the other-side shield layer 6, the one-side shield layer 7, and the side shield layers 9 is formed. FIG. 2F clearly illustrates the boundary between the other-side shield layer 6 and the side shield layer 9 and the boundary between the one-side shield layer 7 and the side shield layer 9 in the shield layer 5. However, the boundaries may be unclear or not observed.

In this manner, the wiring circuit board 1 including the insulating base layer 2, the conductive layer 3, the cover insulating layer 4, and the shield layer 5 is produced.

As illustrated in FIG. 1, the thickness T0 of the wiring circuit board 1 is, for example, 600 µm or less, preferably 300 µm or less, more preferably 200 µm or less, and, for example, 10 µm or more. The width W0 of the wiring circuit board 1 is, for example, 100 µm or more and preferably 600 µm or less. A ratio (T0/W0) of the thickness T0 to the width W0 of the wiring circuit board 1 is, for example, 6 or less, preferably 3 or less, more preferably 1 or less, and, for example, 0.1 or more.

For example, provided that the thickness T1 of the insulating base layer 2 is 50 µm, the thickness T2 of the cover insulating layer 4 is 50 µm, both of the length L1 of the one side part 11 and the length L2 of the other side part 12 are 100 µm on the one-side surface in the thickness direction of the insulating base layer 2, the porous resin layer 10 of the insulating base layer 2 and cover insulating layer 4 has a porosity of 80% and also has a closed cell structure made of polyimide resin, and high-frequency signals of 10 GHz flow through the conductive layer 3 with a thickness T3 of 12 µm and a width W3 of 50 µm; the wiring circuit board 1 with a thickness T0 of 112 µm has transmission loss of, for example, less than 5 dB/100 mm, preferably, 4 dB/100 mm or less, more preferably 3 dB/100 mm or less, even more preferably 2.5 dB/100 mm or less. Thus, the wiring circuit board 1 has excellent properties for transmitting high-frequency signals.

### <Operations and Effects of First Embodiment>

The wiring circuit board 1 includes the insulating base layer 2 and cover insulating layer 4 that are the porous resin layer 10. Thus, the high-frequency signal transmission efficiency can be improved.

The wiring circuit board 1 includes the insulating base layer 2 and cover insulating layer 4 having a layered shape, and thus can be thinned.

When the thickness T1 of the insulating base layer 2 and the thickness T2 of the cover insulating layer 4 are, 0.9 or more and 1.1 or less, the distance T1 from the other-side shield layer 6 (the shield layer 5 facing the insulating base layer 2) to the conductive layer 3 and the distance T2 from the one-side shield layer 7 (the shield layer 5 facing the cover insulating layer 4) to the conductive layer 3 can substantially be the same. Thus, the effect of the magnetic field from the other side in the thickness direction on the conductive layer 3 and the effect of the magnetic field from the one side in the thickness direction on the conductive layer 3 can cancel each other. Accordingly, the effect of the outside magnetic field on the conductive layer 3 can be suppressed. As a result, the wiring circuit board 1 can further more improve the high-frequency signal transmission efficiency.

The wiring circuit board 1 is suitably used as a transmission cable in place of a coaxial cable.

### <Variations of First Embodiment>

In each of the following variations, the same members and steps as in the above-described first embodiment will be given the same numerical references and the detailed description will be omitted. Further, the variations can have the same operations and effects as those of the first embodiment unless especially described otherwise. Furthermore, the first embodiment and the variations can appropriately be combined.

The insulating base layer 2 may not be a porous resin layer 10 but be a densified resin layer (non-porous resin layer). The cover insulating layer 4 may not be a porous resin layer 10 but be a densified resin layer (non-porous resin layer). In short, at least one of the insulating base layer 2 and the cover insulating layer 4 is the porous resin layer 10.

Preferably, as the first embodiment, both of the insulating base layer 2 and the cover insulating layer 4 are the porous resin layer 10. The first embodiment can further more improve the high-frequency signal transmission efficiency and can further be thinned.

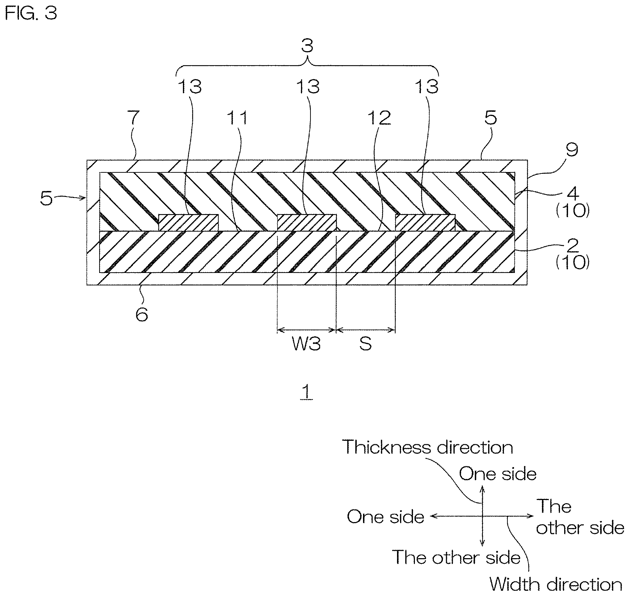

As illustrated in FIG. 3, the conductive layer 3 can include a plurality of wires 13. The wires 13 are disposed in the width direction, holding an interval therebetween. Preferably, the wires 13 are separated at equal intervals in the width direction. An interval S between the adjacent wires 13 is, for example, 5 µm or more, preferably 10 µm or more, and, for example, 100 µm or less, preferably 50 µm or less. A ratio (W3/S) of the width W3 of the wire 13 to the interval S between the adjacent wires 13 is, for example, 0.9 or more, preferably 0.95 or more, and, for example, 1.1 or less, preferably 1.05 or less.

### <Second Embodiment>

In the second embodiment, the same members and steps as in the above-described first embodiment will be given the same numerical references and the detailed description will be omitted. Further, the second embodiment can have the same operations and effects as those of the first embodiment unless especially described otherwise. Furthermore, the first embodiment, the variations, and the second embodiment can appropriately be combined.

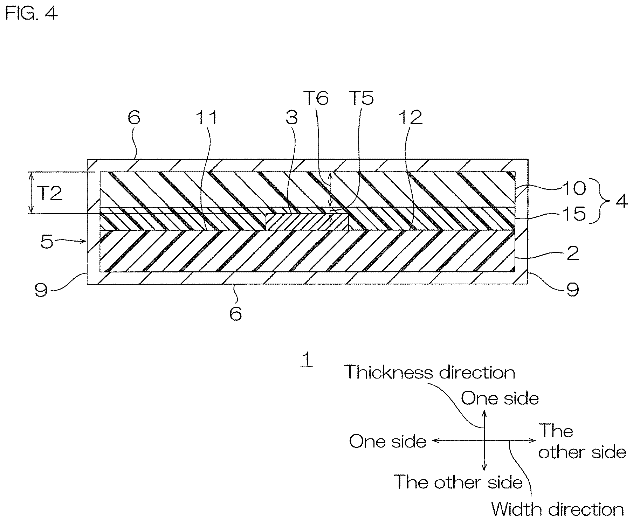

The second embodiment of the wiring circuit board of the present invention is described with reference to FIG. 4.

As illustrated in FIG. 4, the cover insulating layer 4 includes an adhesive layer 15 and a porous resin layer 10. The cover insulating layer 4 sequentially includes an adhesive layer 15 and a porous resin layer 10 toward one side in the thickness direction. Preferably, the cover insulating layer 4 includes only the adhesive layer 15 and the porous resin layer 10.

The adhesive layer 15 is disposed on the one-side surface in the thickness direction of the insulating base layer 2 so as to cover the conductive layer 3. The adhesive layer 15 is in contact with the one-side surface in the thickness direction of the conductive layer 3 and both side surfaces in the width direction of the conductive layer 3 and with a part of the one-side surface in the thickness direction of the insulating base layer 2 that does not overlap the conductive layer 3 when being projected in the thickness direction (specifically, the one side part 11 and the other side part 12). A one-side surface in the thickness direction of the adhesive layer 15 is parallel to the one-side surface in the thickness direction of the insulating base layer 2. Each of both side surfaces in the width direction of the adhesive layer 15 is flush with each of both side surfaces in the width direction of the insulating base layer 2. The adhesive layer 15 has an approximately U shape opening toward the other side in the thickness direction in the cross-sectional view.

The material of the adhesive layer 15 is not especially limited, and examples thereof include hot melt adhesives and thermosetting adhesives. Examples of the adhesives include acrylic adhesive, epoxy adhesives, and silicone adhesives. As the material of the adhesive layer 15, preferably, a material with a low permittivity is selected. When being projected in the thickness direction, the thickness T5 of the adhesive layer 15 overlapping the conductive layer 3 is, for example, 2 µm or more, preferably 5 µm or more, and, for example, 100 µm or less, preferably 15 µm or less. A ratio (T5/T2) of the thickness T5 of the adhesive layer 15 to the thickness T2 of the cover insulating layer 4 is, for example, 10 or less, preferably 1 or less, and, for example, 0.01 or more, preferably 0.1 or more. When the dimensions of the porous resin layer 10 are within the above-described ranges, the wiring circuit board 1 can be thinned while the high-frequency signal transmission efficiency can be improved.

The porous resin layer 10 of the cover insulating layer 4 is disposed on the one-side surface in the thickness direction of the adhesive layer 15. Specifically, the cover insulating layer 4 is in contact with the whole of the one-side surface in the thickness direction of the adhesive layer 15. In the cross-sectional view, the porous resin layer 10 of the cover insulating layer 4 has an approximately rectangular shape with the longest side in the width direction. Each of both side surfaces in the width direction of the porous resin layer 10 is flush with each of both side surfaces in the width direction of the adhesive layer 15. The thickness T6 of the porous resin layer 10 is a distance T6 between the one-side surface in the thickness direction of the adhesive layer 15 and a one-side surface in the thickness direction of the porous resin layer 10. The thickness T6 of the porous resin layer 10 of the cover insulating layer 4 is, for example, 10 µm or more, preferably 25 µm or more, and, for example, 100 µm or less, preferably 75 µm or less. A ratio (T6/T5) of the thickness T6 of the porous resin layer 10 of the cover insulating layer 4 to the thickness T5 of the adhesive layer 15 is, for example, 0.1 or more, preferably 0.5 or more, and, for example, 10 or less, preferably 5 or less. A ratio (T6/T2) of the thickness T6 of the porous resin layer 10 to the thickness T2 of the cover insulating layer 4 is, for example, 1 or less, preferably 0.9 or less, and, for example, 0.05 or more, preferably 0.5 or more. When the dimensions of the porous resin layer 10 are within the above-described ranges, the wiring circuit board 1 can be thinned while the high-frequency signal transmission efficiency can be improved.

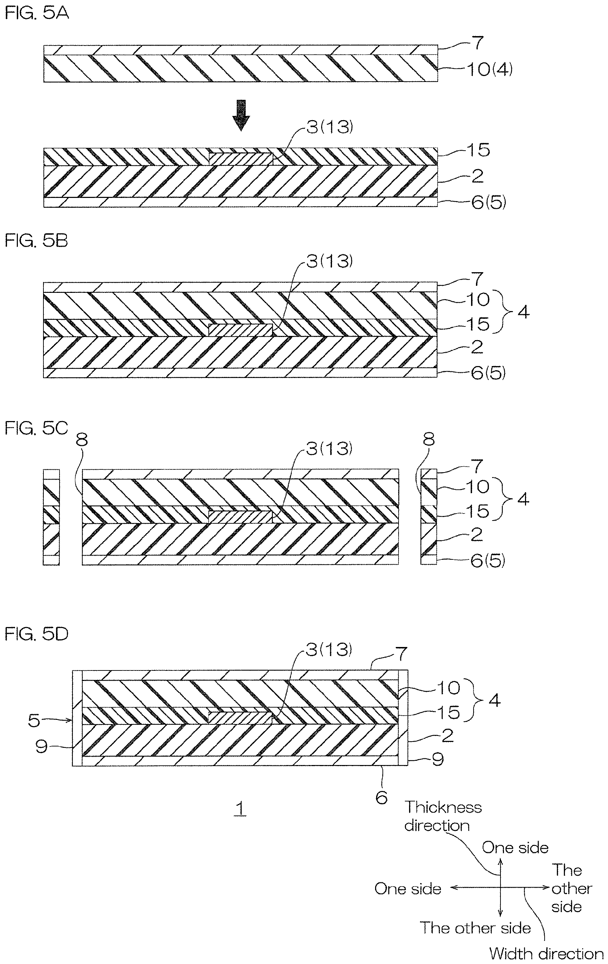

Next, an exemplary method of producing the wiring circuit board 1 of the second embodiment is described with reference to FIG. 2B and FIG. 5A to FIG. 5D. Each of the following steps can be carried out, for example, according to the description in International Patent Publication No. WO2018/186486.

As illustrated in FIG. 2B, the other-side shield layer 6, the insulating base layer 2, and the conductive layer 3 are prepared first in this method. Thereafter, illustrated in FIG. 5A, the adhesive layer 15 is disposed on the insulating base layer 2 and the conductive layer 3. For example, the varnish of an adhesive is applied on the insulating base layer 2 and the conductive layer 3, and dried. Alternatively, the adhesive layer 15 formed on a surface of a peeling sheet in advance is transferred to the insulating base layer 2 and the conductive layer 3.

As illustrated in FIG. 5A, separately, the one-side shield layer 7 and the porous resin layer 10 disposed on the other-side surface in the thickness direction of the one-side shield layer 7 are prepared. A laminate of the porous resin layer 10 laminated on the other-side surface in the thickness direction of the one-side shield layer 7 in advance can be prepared. Alternatively, the one-side shield layer 7 is prepared, and then the porous resin layer 10 is disposed on the other-side surface in the thickness direction of the one-side shield layer 7.

As illustrated by the arrow of FIG. 5A and in FIG. 5B, next in this method, the porous resin layer 10 is brought into contact with the adhesive layer 15. Specifically, the other-side surface in the thickness direction of the porous resin layer 10 and the one-side surface in the thickness direction of the adhesive layer 15 are brought into contact with each other. In this manner, the porous resin layer 10 of the cover insulating layer 4 adheres to the conductive layer 3 and the insulating base layer 2 through the adhesive layer 15. Simultaneously, the cover insulating layer 4 including the porous resin layer 10 and the adhesive layer 15 is formed.

As illustrated in FIG. 5C, next in this method, the opening portion 8 is formed through the other-side shield layer 6, the insulating base layer 2, the cover insulating layer 4 (the adhesive layer 15, the porous resin layer 10), and the one-side shield layer 7.

As illustrated in FIG. 5D, the side shield layer 9 is formed next in this method. The side shield layer 9 is formed on both side surfaces in the width direction of the insulating base layer 2 and both side surfaces in the width direction of the cover insulating layer 4. The side shield layer 9 is formed also on both side surfaces in the width direction of the adhesive layer 15 of the cover insulating layer 4.

In this manner, the wiring circuit board 1 which includes the insulating base layer 2, the conductive layer 3, the cover insulating layer 4, and the shield layer 5, and in which the cover insulating layer 4 includes the porous resin layer 10 and the adhesive layer 15 is produced.

### <Operations and Effects of Second Embodiment>

Of the wiring circuit board 1, a porous resin layer 10 can be provided as the cover insulating layer 4 and the porous resin layer 10 is easily adhered to the insulating base layer 2 and the conductive layer 3 through the adhesive layer 15. Thus, the wiring circuit board 1 can be produced by a simple method.

### <Variations of Second Embodiment>

In each of the following variations, the same members and steps as in the above-described second embodiment will be given the same numerical references and the detailed description will be omitted. Further, the variations can have the same operations and effects as those of the second embodiment unless especially described otherwise. Furthermore, the first, second embodiments, and their variations can appropriately be combined.

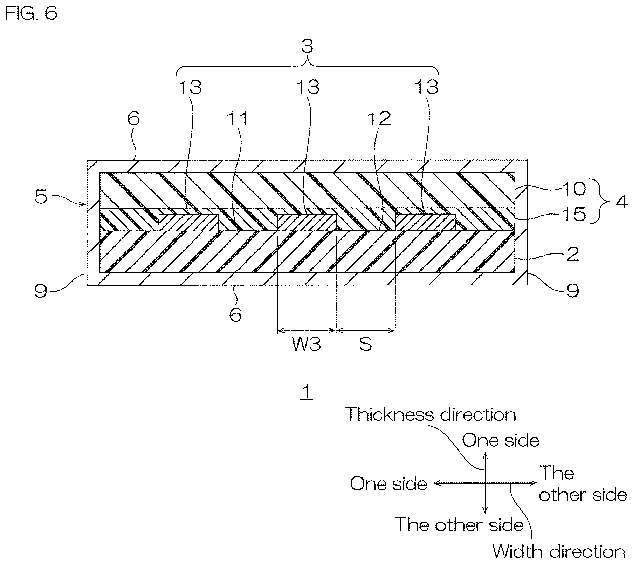

As illustrated in FIG. 6, the conductive layer 3 can include a plurality of wires 13.

Although not illustrated in FIG. 5A, the adhesive layer 15 is first disposed on the other-side surface in the thickness direction of the porous resin layer 10 of the cover insulating layer 4, and brought into contact with the insulating base layer 2 and the conductive layer 3.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The wiring circuit board is used as a transmission channel that transmits signals.

### Description of Reference Numerals

- 1: wiring circuit board
- 2: insulating base layer
- 3: conductive layer
- 4: cover insulating layer
- 5: shield layer
- 10: porous resin layer
- 15: adhesive layer

## Claims

1. A wiring circuit board comprising:
an insulating base layer;
a conductive layer disposed on a one-side surface in a thickness direction of the insulating base layer;
a cover insulating layer disposed on the one-side surface in the thickness direction of the insulating base layer so as to cover the conductive layer; and
a shield layer disposed on the other-side surface in the thickness direction of the insulating base layer and both side surfaces in the width direction of the insulating base layer, and on a one-side surface in the thickness direction and both side surfaces in the width direction of the cover insulating layer, wherein
at least one of the insulating base layer and the cover insulating layer has a porous resin layer.

2. The wiring circuit board according to Claim 1, wherein
a ratio (T2/T1) of a distance T2 between a one-side surface in the thickness direction of the conductive layer and the one-side surface in the thickness direction of the cover insulating layer to a distance T1 between the other-side surface in the thickness direction of the conductive layer and the other-side surface in the thickness direction of the insulating base layer is 0.9 or more and 1.1 or less.

3. The wiring circuit board according to Claim 1, wherein the porous resin layer has a closed cell structure.

4. The wiring circuit board according to Claim 1, wherein the porous resin layer has a porosity of 50% or more.

5. The wiring circuit board according to Claim 1, wherein a material of the porous resin layer is a polyimide resin.

6. The wiring circuit board according to Claim 1, wherein the insulating base layer and the cover insulating layer is made of a porous resin layer.

7. The wiring circuit board according to Claim 1, wherein
the insulating base layer is made of the porous resin layer,
the cover insulating layer includes
an adhesive layer being in contact with a one-side surface in the thickness direction of the conductive layer and both side surfaces in the width direction of the conductive layer and with a part of the one-side surface in the thickness direction of the insulating base layer that does not overlap the conductive layer when being projected in the thickness direction, and
the porous resin layer being in contact with a one-side surface in the thickness direction of the adhesive layer.
